## Europäisches Patentamt
## European Patent Office
## Office européen des brevets

(19)

(11) Numéro de publication : **0 053 533**
**B1**

(12)

# FASCICULE DE BREVET EUROPÉEN

(45) Date de publication du fascicule du brevet :
29.02.84

(51) Int. Cl.³ : **H 03 H 3/04**

(21) Numéro de dépôt : **81401804.0**

(22) Date de dépôt : **17.11.81**

(54) **Procédé de stabilisation dans le temps d'un résonateur piézo-électrique.**

(30) Priorité : 21.11.80 FR 8024803

(43) Date de publication de la demande :
09.06.82 Bulletin 82/23

(45) Mention de la délivrance du brevet :
29.02.84 Bulletin 84/09

(84) Etats contractants désignés :
**CH DE GB IT LI NL**

(56) Documents cités :
**US-A- 2 989 799**
**US-A- 3 914 836**
**PROCEEDINGS OF THE 27th ANNUAL FREQUENCY CONTROL SYMPOSIUM, 12-14 juin 1973, CHERRY HILL (N.Y.) U.S. ELECTRONIC INDUSTRIES ASSOCIATION, J. VIG: "Surface preparation and characterisation techniques for quartz resonators", pages 98-112**
**WESCON TECHNICAL PAPERS, vol. 20, no. 20, 1976, NORTH HOLLYWOOD (US) M. BLOCH: "Crystal survey", pages 32/3-1 à 32/3-14**

(73) Titulaire : **COMPAGNIE D'ELECTRONIQUE ET DE PIEZO-ELECTRICITE - C.E.P.E.**
**44, rue de la Glacière**
**F-95100 Argenteuil (FR)**

(72) Inventeur : **Dube, Georges**
**THOMSON-CSF SCPI 173, bld Haussmann**
**F-75360 Paris Cedex 08 (FR)**

(74) Mandataire : **Vesin, Jacques et al**
**THOMSON-CSF SCPI 173, Bld Haussmann**
**F-75379 Paris Cedex 08 (FR)**

Procédé de stabilisation dans le temps d'un résonateur-piézo-électrique

La présente invention se rapporte au domaine des résonateurs piézo-électrique mis en œuvre dans les applications où une fréquence d'oscillation doit être définie avec une stabilité élevée. C'est le cas, par exemple, des oscillateurs pilotes ou des filtres de fréquence utilisés en radioélectricité et en téléphonie.

De tels résonateurs sont constitués d'un matériau monocristallin tel que le quartz, variété de silice cristallisée, taillé suivant un bloc de forme générale parallélépipédique, et muni d'électrodes sur deux de ses faces opposées pour l'application des tensions électriques nécessaires.

La fréquence d'un résonateur piézo-électrique dépend de certaines de ses dimensions, et on l'ajuste par des opérations mécaniques de meulage en présence de matériaux abrasifs, suivant plusieurs étapes successives, d'abord de dégrossissage et ensuite de finition.

Le résonateur est alors muni de ses électrodes, constituées le plus souvent de couches métalliques minces déposées sur les faces convenables, et, avant utilisation, mis en fonctionnement pendant une durée donnée, dans un montage électrique de formation ou de « vieillissement ».

Il a été, en effet, constaté que ses caractéristiques d'exploitation, dont la principale est sa fréquence d'oscillation, évoluent lentement à température constante pendant les premiers temps de mise en fonctionnement, avant de se stabiliser à une valeur fixe, suivant une loi asymptotique à cette valeur ; à titre d'ordre de grandeur, un résonateur en quartz, oscillant vers 5 MHz, peut demander environ 4 000 heures pour se stabiliser à $1 \cdot 10^{-9}$ par mois de sa fréquence nominale.

Des études approfondies qui ont été effectuées par la Demanderesse pour découvrir les causes de ce phénomène ont montré que les opérations mécaniques de finition en étaient pour une grande partie à l'origine. Lors de la finition d'un quartz, les surfaces principales du cristal sont meurtries. L'élément abrasif laboure la surface et créé des écailles qui sont éliminées au moyen d'un rinçage soigné. Néanmoins, il reste toujours des crevasses et des dislocations superficielles formant une mince couche hétérogène que l'on nomme « zone perturbée ». Lorsque cette zone est exposée à l'humidité, il se produit une érosion de la surface et de ce fait, des particules de quartz — et d'abrasif — se détachent.

En pratique, malgré un nettoyage final chimique en milieu acide, la présence de cette zone perturbée entraîne l'établissement de phénomènes à évolution lente qui expliquent l'évolution dans le temps du résonateur :

— diffusion progressive du matériau métallique des électrodes dans le réseau cristallin perturbé, celui du quartz ayant une structure relativement pénétrable ou « ouverte » ;

— pénétration de vapeur d'eau, d'impuretés atmosphériques.

D'autre part, on doit noter que les opérations d'usinage ont perturbé l'équilibre mécanique du bloc, en y introduisant des tensions, dont le relâchement dans le temps est long.

Il apparaît ainsi que c'est la zone perturbée qui est en partie responsable des phénomènes d'évolution indiqués, et que le remède devrait être l'application d'un revêtement protecteur sur cette zone, soudant entre elles les écailles et obturant les fissures ou crevasses du réseau cristallin disloqué. L'utilisation de revêtements extérieurs n'ont pas donné, jusqu'à ce jour de résultats satisfaisants permettant de constater une amélioration du vieillissement.

Selon le brevet US-A 3 914 836, il est connu d'exposer la surface d'un cristal de quartz à un bombardement d'ions. Cependant comme le bombardement constitue une étape de nettoyage, l'énergie des ions a juste le minimum requis pour enlever les impuretés de la surface du cristal.

Dans la présente demande, le bombardement d'ions constitue une étape d'implantation ionique de manière à transformer la surface du cristal en une couche de silice vitreuse, l'énergie des ions (environ 100 fois plus grande) ayant la valeur requise pour atteindre précisément ce but.

Selon l'invention, on crée une couche de protection continue, en un matériau identique à celui du cristal, sur les surfaces du cristal qui ont été soumises aux opérations mécaniques de finition, cette couche étant constituée de silice amorphe dans le cas du quartz. La caractéristique fondamentale de l'invention est de former cette couche directement à partir du matériau cristallin du résonateur lui-même, par un procédé d'implantation d'ions choisis. Le cristal est ainsi revêtu d'une couche vitrifiée qui le met à l'abri des agressions de l'environnement, et, de plus, la zone perturbée qui a été mentionnée plus haut est rendue homogène: la vitrification réalisée fait disparaître les dislocations et les crevasses superficielles. On constate de plus que, de façon surprenante, le traitement ne modifie pas sensiblement la fréquence d'oscillation. On constate par exemple qu'un quartz dont la fréquence d'oscillation est de 20 MHz a une fréquence d'oscillation qui n'a pas varié de plus de 1 KHz après traitement, ce qui est tout à fait négligeable. On constate, en effet, un gonflement du cristal au cours du traitement, celui-ci compensant la diminution d'épaisseur de la lame piézo-électrique du fait de l'implantation ionique. Ces deux facteurs se compensant approximativement, ceci explique la très faible variation de fréquence d'oscillation du résonateur avant et après traitement.

Bien que la nature des ions à implanter puisse être choisie dans une certaine gamme de masses atomiques, c'est au domaine des ions légers, tels que ceux de l'hélium, le lithium et le béryllium qu'il est particulièrement avantageux de s'adresser, ces ions pénétrant plus facilement dans le réseau cristallin. La densité du faisceau utilisé sera variable suivant le type d'ions utilisés ainsi que le cristal à traiter. D'une façon générale, on a constaté qu'une densité de l'ordre de $1,5 \times 10^{16}$ ions/cm² convenait parfaitement. La tension d'accélération sera dans tous les cas inférieure à 200 kV et de préférence de l'ordre de 100 kV. La durée du traitement est variable suivant la valeur des paramètres ci-dessus et peut varier de préférence entre quelques minutes et plusieurs dizaines de minutes. On a constaté qu'en général, une durée de l'ordre de 10 mn convenait. L'homme de l'art fera varier ces différents paramètres de telle sorte que la couche amorphe obtenue après traitement soit inférieure de préférence, à 1 micron. Selon un mode préférentiel de réalisation, on a constaté qu'une épaisseur de l'ordre de 7 500 Angstroems convenait bien. Ce cristal est ensuite recuit à une température inférieure au point de curie et de préférence de l'ordre de 400 °C. La durée du traitement thermique sera de l'ordre de une heure environ.

La formation de la couche de protection extérieure élimine ainsi les causes énumérées plus haut responsables en partie du vieillissement long d'un résonateur avant stabilisation.

Ainsi, plus précisément, l'invention faisant l'objet du présent brevet consiste en un procédé de stabilisation dans le temps d'un résonateur piézo-électrique cristallin, constitué d'un bloc (1) de matériau à l'état cristallin, caractérisé en ce qu'il comporte une étape d'implantation ionique sur certaines des faces (21, 22) de ce bloc, assurant la transformation du matériau, jusqu'à une profondeur déterminée (23, 24) de celles-ci, à l'état vitreux.

L'invention sera mieux comprise à l'aide de la description ci-après, en s'appuyant sur les figures annexées, où :

la figure 1 représente, suivant deux parties (a) et (b), une vue en coupe d'un résonateur piézo-électrique en cristal de quartz, après abrasion mécanique en vue de la finition,

la figure 2 représente une vue en coupe d'un résonateur piézo-électrique en cristal de quartz, après finition, et application, selon l'invention, du procédé de stabilisation dans le temps par implantation ionique,

la figure 3 représente des courbes comparatives de vieillissement entre un cristal traité et un cristal non traité.

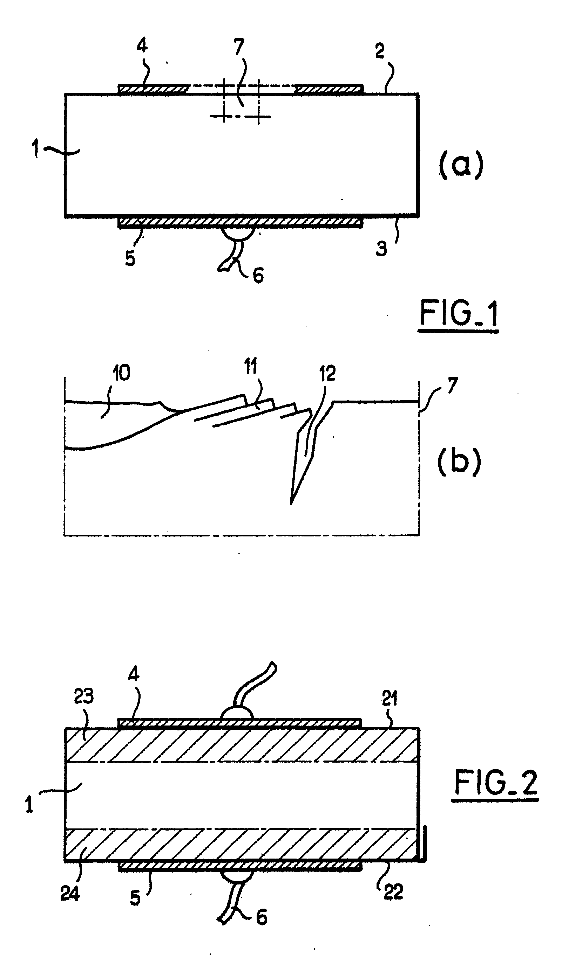

La figure 1 représente, suivant deux parties (a) et (b), une vue en coupe d'un résonateur piézo-électrique en cristal de quartz après abrasion mécanique en vue de la finition.

En (a) est représenté l'ensemble du résonateur 1, avec deux faces principales 2 et 3 en vis-à-vis, dont la distance mutuelle participe à la définition de la fréquence de résonance. Ces faces sont recouvertes d'électrodes 4 et 5, en forme de couches métalliques minces, munies de connexions telles que 6 pour l'application des tensions électriques nécessaires.

Si l'on observe, comme représenté en (b), une portion très agrandie 7 de la surface du cristal, on constate que l'opération de finition y a provoqué un ensemble d'altérations telles que l'arrachement de parcelles en forme d'« écailles » telles que 10, de dislocations du réseau cristallin telles que 11, et de « crevasses » ou fissures telles que 12. Ces altérations ont des conséquences graves, qu'on a décrites plus haut, sur la stabilisation de fonctionnement du résonateur.

La figure 2 représente une vue en coupe d'un résonateur piézo-électrique en cristal de quartz, après finition par abrasion mécanique, mais ayant subi le procédé de stabilisation dans le temps selon l'invention.

Ce procédé, qui consiste en une implantation ionique d'ions légers tels que ceux de l'hélium, du lithium ou du béryllium, sur les deux faces 21 et 22 en vis-à-vis, y détermine la formation de couches superficielles de silice amorphe 23 et 24, qui correspond à l'état de la matière connu sous le nom de « vitreux ». Cette couche continue, créée aux dépens des altérations de surface du résonateur, élimine celles-ci et met le quartz cristallin à l'abri des agressions extérieures, avec les conséquences avantageuses indiquées plus haut ; de plus, son mode de formation à partir du quartz lui-même assure son accrochage ou « ancrage » parfait sur le cristal. Enfin, ce même mode de formation garantit qu'elle ne perturbe pas les caractéristiques d'oscillation/surtension du résonateur, ce que ne sauraient complètement garantir les couches hétérogènes déposées sur les faces principales. De plus, cette couche amorphe provient du cristal lui-même et ne provoque donc pas de surépaisseur.

Exemple

Neuf pastilles de quartz sont disposées selon une matrice 3 × 3 dans une cloche à vide. Ces pastilles sont soumises pendant dix minutes à un faisceau d'ions d'hélium ayant une densité de $1,5 \times 10^{16}$ ions He⁺ par cm² avec une tension d'accélération de 100 kV. On obtient une couche de silice amorphe (à l'état vitreux) d'environ 7 500 Angstroems. Les pastilles sont ensuite retournées et, après avoir fait le vide, sont soumises sur l'autre face au même traitement que ci-dessus. Après recuit à 400 °C pendant une heure, les pastilles sont prêtes à être métallisées (réalisation des électrodes). Les pastilles sont ensuite montées dans un boîtier selon la technique habituelle.

Les résonateurs ayant subi ce traitement sont soumis à un vieillissement dans une enceinte thermostatée à 70 °C. On fait subir le même vieillissement à un groupe de résonateurs identiques, mais non traités, montés de la même manière dans des boîtiers identiques.

On doit noter que les ordres de grandeur ci-dessus sont donnés à titre d'exemple, et que toute variante dans le procédé d'implantation décrit, qui en conserve les caractéristiques et résultats d'ensemble c'est-à-dire permettant de rendre amorphe la partie superficielle du quartz sur une épaisseur inférieure à environ un micron, est compris dans le domaine de l'invention.

De même, c'est le quartz cristallin qui a été indiqué dans la description ci-dessus ; il est cependant compris dans le domaine de l'invention d'utiliser le procédé d'implantation, pour d'autres cristaux piézo-électriques, avec les variantes nécessitées par les différences des matériaux, au tantalate de lithium et au niobate de lithium.

Enfin, il est à remarquer que l'utilisation du procédé d'implantation décrit plus haut en vue de stabiliser les caractéristiques d'oscillation d'un résonateur piézo-électrique, apporte simultanément une amélioration dans la courbe caractéristique de la variation de fréquence en fonction de la température. De plus, on constate que la courbure (ou l'ouverture) de cette courbe est modifiée au point d'inversion, c'est-à-dire que le coefficient du second ordre est diminué d'un facteur 2 à 3.

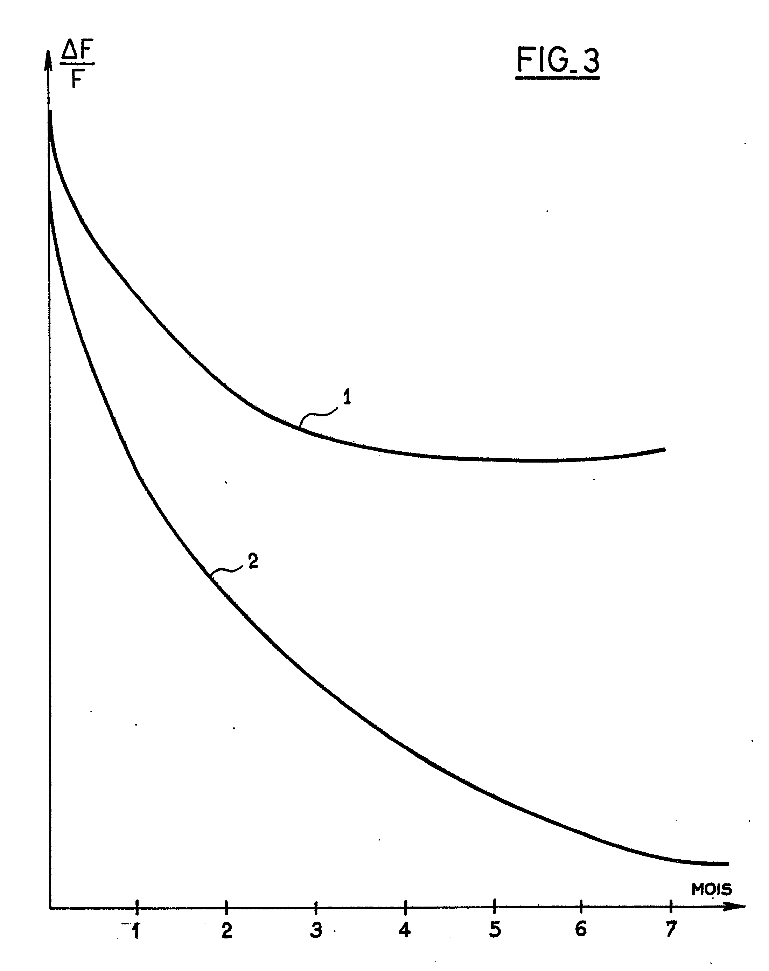

Les résultats sont montrés sur la figure 3 qui représente les variations relatives de fréquence $\Delta F/F$ de la pastille de quartz en fonction du temps.

La courbe (1) est relative à un cristal traité selon l'exemple ci-dessus, la courbe (2) étant relative à un cristal de même origine, mais non traité.

On constate que pour un cristal traité selon l'invention, la pente de la courbe devient très faible après trois mois environ alors que pour les cristaux non traités, cette pente ne s'affaiblit qu'après environ huit mois de vieillissement. Toutefois, la pente de la courbe relative aux cristaux non traités reste toujours de l'ordre de 3 à 4 fois supérieure à celle de la courbe relative aux cristaux traités, même après un an ou plus.

**Revendications**

1. Procédé de stabilisation dans le temps des caractéristiques d'oscillation d'un résonateur piézo-électrique, constitué d'un bloc (1) de matériau à l'état cristallin caractérisé en ce qu'il comporte une étape d'implantation ionique sur certaines des faces (21, 22) de ce bloc, assurant la transformation du matériau jusqu'à une profondeur déterminée (23, 24) de celles-ci, à l'état vitreux.

2. Procédé de stabilisation selon la revendication 1, caractérisé en ce que la profondeur déterminée est comprise entre 0 et 1 micromètre.

3. Procédé de stabilisation selon l'une des revendications 1 et 2, caractérisé en ce que les ions mis en œuvre dans ladite implantation ionique sont des ions légers d'hélium, de lithium ou de béryllium.

4. Procédé de stabilisation selon l'une des revendications 1 à 3, caractérisé en ce qu'il comporte les étapes suivantes :
— disposer le résonateur dans une cloche à vide,
— soumettre sa face supérieure au faisceau ionique pendant environ dix minutes,
— retourner le résonateur et recommencer les étapes ci-dessus pour traiter l'autre face du résonateur.

5. Procédé de stabilisation selon la revendication 4, caractérisé en ce que le résonateur subit ensuite une opération de recuit à une température inférieure au point de curie du matériau utilisé.

6. Procédé de stabilisation selon l'une des revendications 1 à 5, caractérisé en ce que ledit matériau à l'état cristallin est du quartz.

7. Procédé de stabilisation selon l'une des revendications 1 à 5, caractérisé en ce que ledit matériau est du tantalate de lithium.

8. Procédé de stabilisation selon l'une des revendications 1 à 5, caractérisé en ce que ledit matériau est du niobate de lithium.

**Claims**

1. A method for stabilizing in time the oscillation characteristics of a piezoelectric resonator formed from a block (1) of material in the crystalline state, characterized in that it comprises a step of implating ions on certains faces (21, 22) of said block, ensuring the transformation of the material to the vitreous state up to given depth (23, 24).

2. A stabilisation method according to claim 1, characterized in that the given depth is between 0 and 1 $\mu$m.

3. A stabilisation method according to one of the claims 1 and 2, characterized in that the ions used in that ionic implantation step are light ions of helium, lithium or beryllium.

4. A stabilisation method according to one of the claims 1 to 3, characterized in that it comprises the following steps :
— disposing the resonator in a vacuum bell jar,
— subjecting its upper face to the ion beam for about 10 minutes,
— turning the resonator over and starting again the above steps so as to treat the other face to the resonator.

5. A stabilisation method according to claim 4, characterized in that the resonator then undergoes a reheating operation at a temperature less than the Curie point of the employed material.

6. A stabilisation method according to one of the claims 1 to 5, characterized in that said material in the crystalline state is quartz.

7. A stabilisation method according to one of the claims 1 to 5, characterized in that the material in the cristalline state is lithium tantalate.

8. A stabilisation method according to one of the claims 1 to 5, characterized in that the material in the cristalline state is lithium niobate.

**Ansprüche**

1. Verfahren zur zeitlichen Stabilisierung der Schwingungskennwerte eines piezoelektrischen Resonators, der von einem Block (1) eines kristallinen Materials gebildet wird, dadurch gekennzeichnet, daß es einen Verfahrensschritt aufweist, in dem in gewisse Oberflächen (21, 22) dieses Blocks Ionen implantiert werden, wodurch das Material bis zu einer bestimmten Tiefe (23, 24) in den glasartigen Zustand übergeht.

2. Verfahren zur Stabilisierung nach Anspruch 1, dadurch gekennzeichnet, daß die bestimmte Tiefe zwischen 0 und 1 $\mu$m liegt.

3. Verfahren zur Stabilisierung nach einem der Ansprüche 1 und 2, dadurch gekennzeichnet, daß leichte Ionen des Heliums, Lithiums oder des Berylliums implantiert werden.

4. Verfahren zur Stabilisierung nach einem der Ansprüche 1 bis 3, dadurch gekennzeichnet, daß es folgende Schritte aufweist :

— der Resonator wird in eine Vakuumglocke gebracht,

— seine Oberseite wird während etwa 10 Minuten einen Ionenstrahl ausgesetzt,

— der Resonator wird umgedreht, und die obigen Schritte werden wieder begonnen, um die andere Oberseite des resonators zu behandeln.

5. Verfahren zur Stabilisierung nach Anspruch 4, dadurch gekennzeichnet, daß der Resonator dann einer Wärmebehandlung bei einer Temperatur unterhalb des Curiepunktes des verwendeten Materials unterliegt.

6. Verfahren zur Stabilisierung nach einem der Ansprüche 1 bis 5, dadurch gekennzeichnet, daß das kristalline Material Quarz ist.

7. Verfahren zur Stabilisierung nach einem der Ansprüche 1 bis 5, dadurch gekennzeichnet, daß das kristalline Material Lithiumtantalat ist.

8. Verfahren zur Stabilisierung nach einem der Ansprüche 1 bis 5, dadurch gekennzeichnet, daß das kristalline Material Lithiumniobat ist.

FIG_1

(a)

(b)

FIG_2

FIG. 3